# EUROPEAN PATENT APPLICATION

(11) **EP 0 595 484 A1**
(43) Date of publication of application: **04.05.1994**
(21) Application number: 93307831.3
(22) Date of filing: 01.10.1993
(51) Int. Cl.: H01L 21/82, H01L 27/06, H01L 27/092

(54) **NMOS LDD PMOS HALO IC process for CMOS transistors**

(30) Priority: 22.10.1992 US 964929
(71) Applicant: NATIONAL SEMICONDUCTOR CORPORATION, Santa Clara, California 95052-8090 (US)
(72) Inventor: Robinson, Murray J., Falmouth, Maine 04105 (US); Joyce, Christopher C., Gorham, Maine 04038 (US)
(74) Representative: Bowles, Sharon Margaret

(57) **Abstract**

A low dose of N type dopant material is introduced in the source and drain regions of CMOS transistors using the polygate POLY and field oxide regions FOX as a self aligned transistor SAT mask and forming a lightly doped N-LDD layer in the source and drain regions of NMOS transistors and a lightly doped halo layer PHLDD in the source and drain regions of PMOS transistors. A PMOS transistor P+S/D definition mask, etch and P type dopant material introduction sequence introduces P+ concentration source and drain regions in the PMOS transistors over the N- halo layer. The P+S/D implant is adjusted for erasing the halo layer along the horizontal interface between the source and drain regions and underlying NWELL but preserving the halo layer at the ends of the channel under the polygate between the source and drain regions of the PMOS transistors. The localized halo PHLDD of N type dopant material at the ends of the channel enhances punch through protection between the source and drain regions of the PMOS transistors by 20% - 30% without substantially increasing parasitic capacitance between the NWELL and source and drain regions. The N+S/D definition mask, etch and N+ dopant material introduction sequence for NMOS transistors retains a portion of the N-LDD layer along the horizontal interface for reducing parasitic capacitance and at the edges of the channel for hot electron protection of the gate oxide of NMOS transistors. The new architecture for source and drain regions of CMOS transistors and new IC fabrications steps provide enhanced punch through protection for PMOS transistors and hot electron protection for NMOS transistors while reducing parasitic capacitance across active areas of the CMOS transistors.

## Description

### Technical Field

This invention relates to a new architecture for the source and drain regions of CMOS transistors and to new IC process steps for fabricating the improved CMOS transistors applicable in both CMOS and BICMOS IC fabrication processes. The invention provides hot electron protection for the gate oxide layer of NMOS transistors, provides enhanced punch through protection between source and drain regions of PMOS transistors, and reduces parasitic capacitance across active areas of CMOS transistors.

### Background Art

A BICMOS IC fabrication process for fabricating both bipolar NPN and CMOS transistor structures recently in use at National Semiconductor Corporation, South Portland, Maine 04106 is summarized in TABLE I showing the overall BICMOS mask sequence. A brief description follows TABLE I. Further description of the BICMOS process mask sequence and sequence steps is also found in the Murray J. Robinson, Christopher C. Joyce, and Timwah Luk U.S. Patent Application Serial No. 655,676 filed February 14, 1991 for BIPOLAR TRANSISTOR STRUCTURE AND BICMOS IC FABRICATION PROCESS, now abandoned; the Robinson, Joyce, and Luk U.S. Patent Application Serial No. 803,214 filed December 6, 1991 for SCHOTTKY DIODE STRUCTURE AND FABRICATION PROCESS; the Donald J. Desbiens U.S. Patent Application Serial No. 840,390 filed February 24, 1992 for WAFER LEVEL RELIABILITY CONTACT TEST STRUCTURE; and the Robinson and Joyce U.S. Patent Application Serial No. 905,772 filed June 29, 1992 for SIMPLIFIED HIGH RELIABILITY GATE OXIDE PROCESS. The Joyce and Robinson U.S. Patent Application Serial No. 942,977, filed September 10, 1992 for LATERAL PNP TRANSISTOR STRUCTURE AND BICMOS IC FABRICATION PROCESS incorporates bipolar PNP transistors in the BICMOS process.

**TABLE I**

| BICMOS WAFER FABRICATION MASK SEQUENCE | |
|---|---|
| Mask No. | Mask Function |
| 1.0 | N+ Buried Layer (N+BL) or NPN Buried Collector Layer (BCL) Mask |
| 2.0 | PMOS Retro NWELL Mask and NPN Retro SEC Mask |
| 3.0 | NMOS Retro PWELL Mask and Channel Stop (CHST) Mask |
| 4.0 | Isolation Oxide (ISOX) Mask |
| 5.0 | NPN Collector Sink (N+SINK) Definition Mask & ISOX Gettering Mask |
| 6.0 | CMOS Active Area Definition Mask (Active Mask) or Field Oxide (FOX) definition Mask & NPN Collector Base Surface Spacer (CBSS) Definition Mask |
| 7.0 | CMOS Actice Strip Mask |
| 8.0 | Poly Gate (POLY) Definition Mask |
| 9.0 | NPN Base Definition Mask |
| 10.0 | 2nd CVD Nitride Layer Etch Mask and NPN Collector Base & Emitter Contact Definition Mask |
| 11.0 | NPN Emitter Definition Mask & Collector Sink Contact Mask (Self-Aligned Transistor SAT Mask) |
| 12.0 | PMOS P+S/D Source/Drain Mask |
| 13.0 | NMOS N+S/D Source/Drain Mask |
| 14.0 | CMOS Contact Definition Mask |
| 15.0 | METAL 1 (M1) Definition Mask |
| 16.0 | VIA Mask (Inter Layer Dielectric Mask) |
| 17.0 | METAL 2 (M2) Definition Mask |
| 18.0 | Passivation Mask and Bond Pas Definition Mask |

A buried collector layer BCL for bipolar NPN transistors is formed typically in a P type substrate PSUB using the 1.0 BCL or N+BL mask, etch, and N type dopant material introduction sequence at the beginning of the BICMOS wafer fabrication process. The 1.0 N+BL mask is provided by a photoresist layer formed with openings defining the N+ buried layers and exposing an initial oxide layer over the substrate PSUB. Relatively slow diffusing N type antimony atoms are implanted in the P type substrate through the 1.0 mask openings and initial oxide layer to an N+ concentration. The 1.0 mask is removed and a new photoresist layer is then deposited to form the 2.0 Retro NWELL mask.

The 2.0 retro NWELL mask sequence provides the Retro NWELL definition mask, etch, and N type impurity ion introduction sequence through NWELL openings for the CMOS/PMOS transistor structures. At the same time, it also provides a subemitter collector (SEC) region definition mask, etch, and N type impurity ion introduction sequence through SEC openings for the bipolar NPN transistor structures. By way of example, an SEC opening in the 2.0 Retro NWELL mask is formed with a horizontal area of approximately 10% and preferably in the range of 10% to 20% of the horizontal cross section area of the BCL. Relatively fast diffusing phosphorous atoms are implanted in the substrate PSUB to an N+ concentration level through the 2.0 mask openings. Phosphorous atoms are used for the N+ concentration implant of the SEC and NWELL regions for faster up diffusion during subsequent annealing steps as hereafter described to provide retrograde concentrations extending into the subsequently deposited epitaxial layer EPI.

The 3.0 Retro PWELL mask, etch, and P type dopant material introduction sequence is used for defining and introducing the Retro PWELL regions for the CMOS/NMOS transistor structures and the channel stop regions CHST adjacent to the bipolar transistor structures. Boron atoms are implanted to a P+ concentration level in the PWELL and CHST regions through the 3.0 Retro PWELL mask openings. A single crystal epitaxial layer EPI of lightly doped N type silicon at an N- concentration is then deposited uniformly over the BICMOS IC structure in a blanket epitaxial deposition without a mask. The localized retrograde concentrations RETRO of P and N type material are initiated by diffusion upward from the Retro PWELL and Retro NWELL into the epitaxial layer EPI. An epitaxial oxide layer EPIOX and a first chemical vapor deposition CVD nitride layer CVDSIN are formed over the EPI.

Isolation oxide regions ISOX are established around the bipolar transistor structures using the 4.0 isolation oxide mask, etch and isolation oxide grow sequence. The NPN collector sink regions CS or N+SINK are defined by introducing an N+ concentration of phosphorous atoms using the 5.0 sink definition mask, etch and N type impurity ion introduction sequence. The 5.0 N+SINK definition mask is also formed with openings for introducing phosphorous atoms as a gettering agent in the isolation oxide regions ISOX. A second uniform CVD nitride layer is deposited in a blanket chemical vapor deposition across the BICMOS structure.

The 6.0 active area definition mask or Active Mask is formed with openings for etching the second CVD nitride layer CVDSIN around the active regions of the CMOS transistor structures. The openings in the 6.0 photoresist active mask expose the epitaxial layer EPI for growing field oxide regions FOX for framing and isolating the PMOS and NMOS transistor structures. Field oxide FOX is grown during the subsequent field oxide grow oxidation step.

At the same time the 6.0 Active Mask, etch and field oxide grow sequence also functions as the collector base surface spacer region CBSS definition mask, etch, and CBSS oxide grow sequence for the bipolar NPN transistor structures. The 6.0 photoresist active area definition mask functioning as a CBSS mask exposes the EPI surface area between the collector and base of bipolar transistors for the CBSS. In the subsequent field oxidation step, the collector base surface spacer region CBSS between the collector and base of bipolar transistors is formed from field oxide FOX.

In the 7.0 active strip mask, etch, CMOS transistor voltage threshold (V_{T}) adjust, and gate oxide grow sequence steps, the second CVD nitride layer is stripped except over the bipolar NPN transistor structures. Voltage threshold V_{T} of CMOS transistors is adjusted in a blanket P type material introduction step. In a series of subsequent steps sometimes referred to as the gate oxide loop or gate oxide sequence, the active areas of the CMOS transistor structures are opened to expose the epitaxial silicon and to grow a gate oxide layer GOX. These steps are described in detail in U.S. Patent Application Serial No. 905,772 for SIMPLIFIED HIGH RELIABILITY GATE OXIDE PROCESS referenced above.

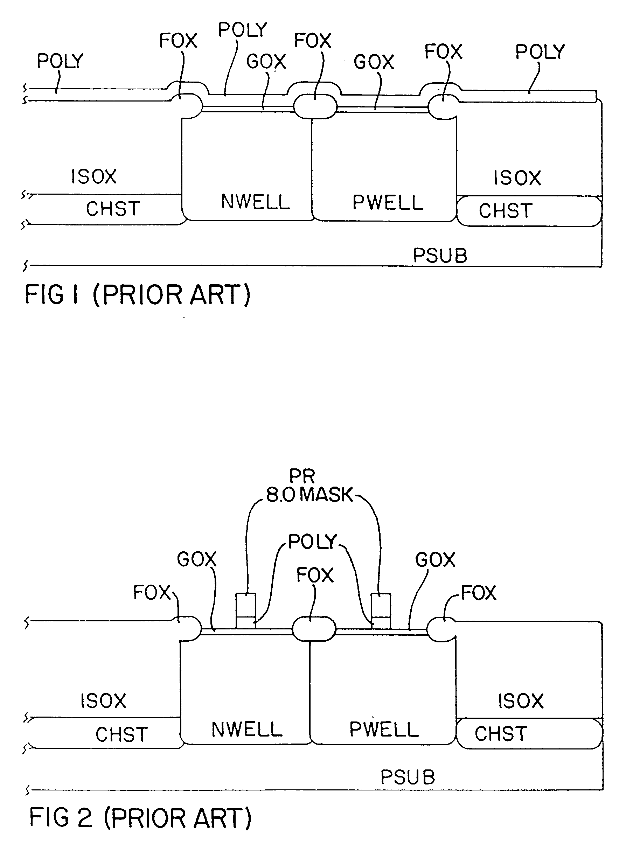

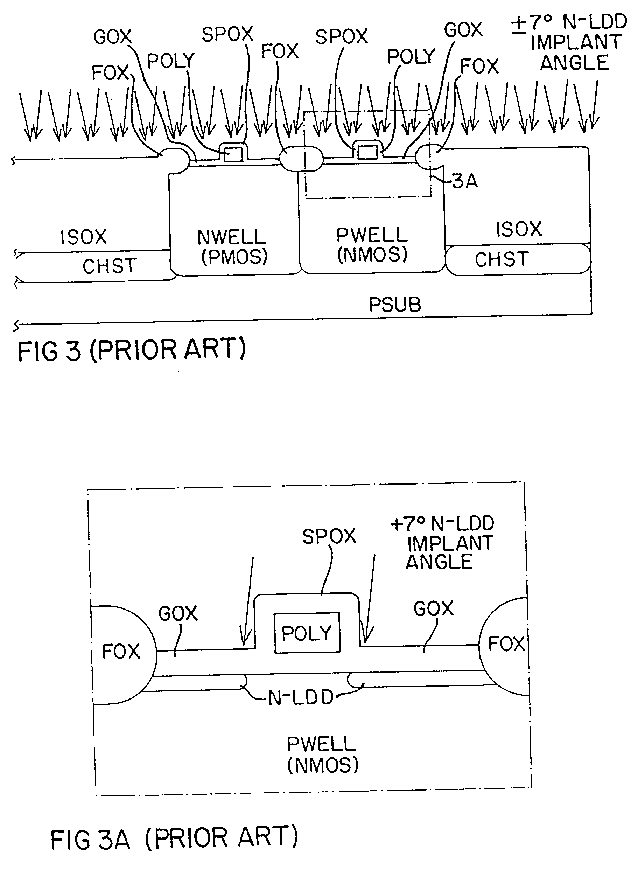

Gate material polysilicon (POLY) is subsequently deposited uniformly in one or two layers as illustrated in Fig. 1 with reference to CMOS transistor structures. The 8.0 poly gate definition mask and etch steps critically define the gates for CMOS transistors using a photoresist layer and photolithographic stepper sequence. The POLY layer is etched leaving behind the POLY gates over the gate oxide layer of CMOS transistors as shown in Fig. 2. No POLY is left over the bipolar NPN transistors which are not shown. A thin oxide layer referred to as a sealing oxide or spacer oxide SPOX is grown over the POLY gates. A lightly doped source and drain N type dopant material introduction sequence such as an N- concentration implant follows using the polygates POLY and FOX as a self-aligned transistor SAT mask. This N-LDD implant initiates preparation of the profile of source and drain regions of CMOS transistors illustrated in Fig. 3 and 3A as hereafter more fully described.

The 9.0 NPN base definition mask, etch and introduction sequence is used for defining and introducing P type boron atoms for the base B of the bipolar NPN transistor structures. The base is implanted through the second CVD nitride layer CVDSIN which functions as a base implant screen. The 10.0 nitride etch mask provides a collector C, base B and emitter E contact definition mask using the second CVD nitride layer and forming a self-aligned transistor (SAT) CVD nitride mask over the bipolar NPN transistor structures. The epitaxial oxide layer EPIOX remains over the bipolar NPN transistor structures with the CVD nitride SAT mask openings defining the collector, base and emitter contacts.

The 11.0 NPN emitter definition and collector sink contact mask is constructed to utilize the underlying CVD nitride SAT mask over the bipolar NPN transistor structures. The emitter region E and collector sink contact region is implanted to an N+ concentration level with N type arsenic atoms. While previous annealing steps have begun development of the retrograde concentration upward through the epitaxial layer EPI from the PWELL, NWELL, and the SEC regions, the subsequent emitter annealing step following implant of the NPN emitter and collector sink contact regions fully develops most of the retrograde concentration profile of dopant atoms. The emitter anneal sequence is described in further detail in U.S. Patent Application Serial No. 905,772 filed June 29, 1992 for SIMPLIFIED HIGH RELIABILITY GATE OXIDE PROCESS referenced above.

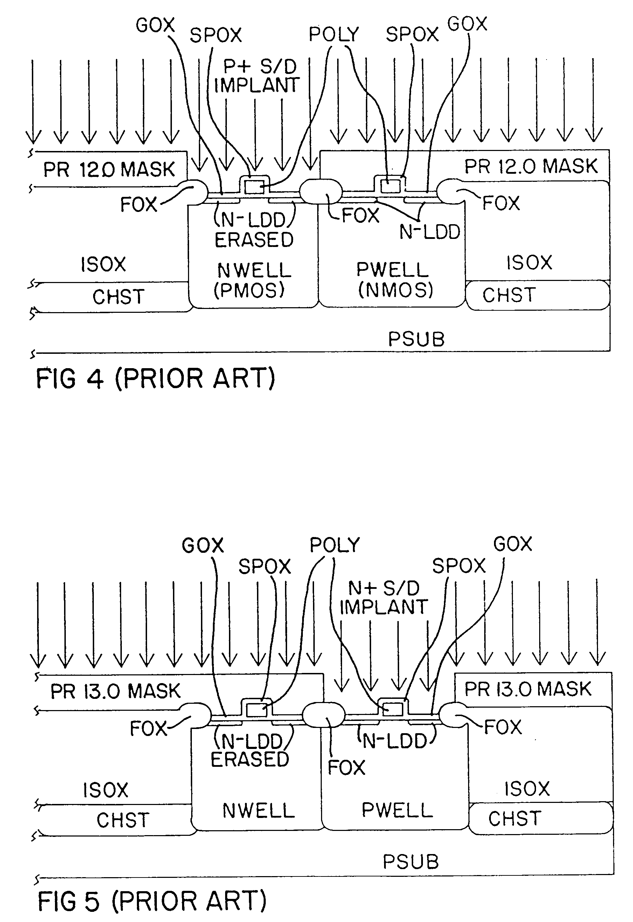

The 12.0 P+S/D source/drain mask, etch and P type dopant material introduction sequence is used for forming the P+ concentration source and drain regions of the PMOS transistor structures as shown in Fig. 4. The P+ concentration implant is adjusted to "swamp" and cancel the previous N- LDD implant layer in the PMOS NWELL. The 13.0 N+S/D source/drain mask, etch and N type impurity ion introduction sequence for the NMOS transistor elements illustrated in Fig. 5 provides an N+ phosphorus implant over the previous lightly doped drain N- phosphorus implant in the source and drain regions and is adjusted to retain a portion of the N-LDD layer. The sequential formation and combination of the N-LDD layer and the N+ source and drain regions develops a profiled lightly doped drain for the NMOS transistor elements of the CMOS transistor pairs to reduce occurrence of "hot electrons".

As used in the specification and claims, ion carriers and dopant atoms introduced into the integrated circuit semiconductor material regions are designated N type for ions or atoms which introduce negative electron carriers into the semiconductor material regions and P type for ions and atoms which introduce positive hole carriers into the semiconductor material regions. The relative concentration of the designated carriers attained in a particular region are indicated by minus and plus signs following the designated P type or N type carriers. For example a double minus sign -- indicates the lowest relative concentration, a single minus sign - indicates an intermediate relative concentration, and a plus sign + or double plus sign ++ indicate relatively higher levels of concentration of the respective designated carrier. This indication of relative concentration of carriers also indicates relative conductivities of the respective semiconductor material regions.

Following the source/drain mask, etch and dopant material introduction sequences for the NMOS and PMOS transistor elements of the CMOS transistor structure, a blanket low temperature oxide layer LTO is deposited over the BICMOS structure. The 14.0 CMOS contact definition mask and etch sequence removes the LTO over the CMOS metal contact areas and over the bipolar transistor structure. The SAT CVD nitride mask on the bipolar transistor structures defines the bipolar transistor metal contact areas. Platinum is deposited and sintered forming platinum silicide over the metal contact areas. Unsilicided platinum is removed in a field etch. In subsequent mask steps the first metal layer is deposited and then selectively etched using the 15.0 Metal 1 or M1 definition mask and etch sequence for defining M1 metal contacts, followed by blanket deposition of an interlayer dielectric (ILD). The ILD is masked and etched using the 16.0 VIA mask to define the locations of interlayer contacts followed by blanket deposition of the second metal layer. The 17.0 Metal 2 or M2 definition mask and etch sequence defines the M2 metal contacts. A passivation layer such as a PECVD oxynitride layer is deposited over the BICMOS structure and the final 18.0 passivation mask and etch sequence cuts holes in the PECVD layer for bond pads.

Referring in more detail to the process steps illustrated in Figs. 3 and 3A, the N- lightly doped drain or low doped drain LDD implant initiates an "architecture" for the source and drain regions of NMOS transistors which provides a concentration profile from the P- concentration PWELL through the N- concentration N-LDD layer to the N+S/D source and drain regions. This graded concentration profile tempers and reduces occurrence of "hot electrons" which may damage the gate oxide layer GOX between the NMOS transistor gate and source and drain regions of the PWELL. The N- concentration LDD layer is formed in the source and drain regions of the NMOS transistors using the polygate POLY and field oxide framing regions FOX as a self-aligned transistor mask. A dual angle implant reduces the shadow effects of the SAT mask structures. For example the N- LDD ions are implanted in two steps at first and second angles +7° and -7° on either side of the vertical as indicated in Figs. 3 and 3A.

The first step of the N- LDD implant using the polygate POLY and field oxide regions FOX as a self aligned transistor SAT mask is shown in detail in Fig. 3A. N type impurity ions are implanted at an angle of +7° from the vertical. For example 1.5 x 10¹³ (1.5E13) ions/cm² are implanted at an energy of 60KEV. In the second step a similar quantity of ions are implanted at 60KEV at an implant angle of -7° from the vertical. The dual implant totaling 3E13 ions/cm² at 60KEV compensates for the shadow effects of the SAT mask.

The original N-LDD implant was formerly a low dose N- concentration arsenic implant used in the early BICMOS process. To save a mask sequence, a low dose of arsenic was blanket implanted in both the PMOS active area NWELL and the NMOS active area PWELL as illustrated in Figs. 3 and 3A. The unwanted N-LDD implant layer or region in the NWELL of PMOS transistors was subsequently erased by "swamping" the N-LDD layer in the subsequent P+S/D PMOS source and drain definition mask, etch and implant steps. The unwanted N-LDD layer in PMOS transistors was therefore effectively eliminated or "erased". In the NMOS transistors, however the N-LDD layer is retained during the 13.0 N+S/D mask implant to provide a graded concentration profile for hot electron protection. Subsequently phosphorous replaced arsenic for the N-LDD implant.

It was subsequently discovered by the inventors that the faster diffusing phosphorous implant N-LDD layer could be used to advantage in the PMOS transistors as well as the NMOS transistors. According to the invention it was discovered that the N-LDD layer in the NWELL of PMOS transistors could be used to solve the problem of enhancing "punch through" protection between the source and drain regions of PMOS transistors. This is particularly useful as the sizes of component elements of an integrated circuit are reduced, for example as in a 1µ or smaller BICMOS IC fabricated process. Furthermore, this could be accomplished without substantially increasing parasitic capacitance between the NWELL and P+ source and drain regions. The punch through problem in PMOS transistors is analyzed in further detail as follows.

In the CMOS active region, the source of PMOS transistors is typically grounded to the NWELL or bulk. As increasing negative reverse bias voltage is applied to the drain electrode, the depletion region extends from the drain across the channel under the PMOS transistor gate, finally reaching the source region. "Punch through" occurs and the PMOS transistor becomes conducting typically at a reverse bias voltage of, for example, 7 volts. A higher punch through voltage threshold level is desirable and can be achieved by increasing the doping concentration of the NWELL. However as you increase the N type impurity doping concentration of the NWELL, the parasitic capacitance across the active area of the PMOS transistor between the NWELL and P+ source and drain regions also increases. The permitted tolerances for such parasitic capacitance therefore typically limits the punch through voltage threshold protection for PMOS transistors to approximately 7 volts.

Similar fabrication steps including the dual angle N-LDD introduction sequence are used in a pure CMOS wafer fabrication process summarized in the following TABLE II.

**TABLE II**

| CMOS WAFER FABRICATION MASK SEQUENCES | |
|---|---|
| Mask No. | Mask Function/Name |
| 0 | PWELL Definition Mask |
| 1.0 | Active Area Definition Mask |
| 2.0 | PWELL Field Implant Mask |
| 3.0 | Polygate (POLY) Definition Mask |
| | (Gate Definition Mask For CMOS Transistors) |
| 4.0 | N⁺S/D Source/Drain Implant Mask |
| | (Self-Aligned NMOS Transistor Mask) |
| 4.1 | P⁺S/D Source/Drain Implant Mask |
| | (Self-Aligned PMOS Transistor Mask) |
| 5.0 | Contact Definition Mask |
| 6.0 | Metal 1 (M1) Definition Mask |
| 7.0 | VIA Mask |
| | (Second Contact Definition Mask) |
| 8.0 | Metal 2 (M2) Definition Mask |
| 9.0 | Passivation Definition |

Further description of such a CMOS fabrication process is set forth for example in the Donald J. Desbiens U.S. Patent Application Serial No. 840,390, filed February 24, 1992 for WAFER LEVEL RELIABILITY CONTACT TEST STRUCTURE AND METHOD. The N-LDD introduction sequence may be incorporated in the 3.0 polygate (POLY) definition mask, etch and introduction sequence steps followed by similar N+S/D and P+S/D mask, etch and introduction sequence steps, all as illustrated in Figs. 1-5.

### Objects of the Present Invention

It is an object of the present invention to provide a new "architecture" and structure for the source and drain regions of CMOS transistors making use of the N-LDD introduction sequence and N-LDD layer for both NMOS and PMOS transistors.

Another object of the invention is to provide a new IC fabrication process which makes use of the dual angle N-LDD phosphorous implant following the polygate POLY definition mask and etch sequence not only for the NMOS transistor elements but also the PMOS transistor elements. The new process is intended to be applicable for both BICMOS and pure CMOS IC fabrication processes.

A further object of the invention is to provide a new source/drain structure for PMOS transistors which provides hot electron protection for the gate oxide of NMOS transistors while enhancing punch through protection between source and drain regions of PMOS transistors. At the same time the new structure and process are intended to reduce parasitic capacitance across the active areas of CMOS transistors.

### Disclosure of the Invention

In order to accomplish these results, the invention provides an improved IC fabrication process incorporating CMOS fabrication steps for preparing CMOS transistors in a substrate of semiconductor material. The CMOS transistors include NMOS transistors having a PWELL, spaced apart source S and drain D regions of N type dopant material in the PWELL, and a polysilicon gate or polygate separated by a gate oxide GOX layer from the source and drain regions and PWELL. The polygate POLY defines a channel in the PWELL under the polygate. The CMOS transistors also include PMOS transistors having an NWELL, source S and drain D regions of P type dopant material formed in the NWELL, and a polygate POLY separated from source and drain regions and NWELL by the gate oxide GOX layer. Similarly, the polygate defines a channel in the NWELL under the polygate.

The invention provides the steps of introducing a relatively low dose of N type dopant material in the S and D regions of CMOS transistors using the polygate as a self aligned transistor SAT mask and forming a low doped N type LDD layer N-LDD in the S and D regions of NMOS transistors and a low doped N type halo layer PHLDD in the S and D regions of PMOS transistors.

According to the invention a PMOS transistor P+S/D definition mask, etch and P type dopant material introduction sequence introduces relatively high P+ concentration S and D regions in the PMOS transistors over the halo layer. The process continues by adjusting the P+S/D implant for erasing the halo layer along the horizontal interface between the PMOS transistor S and D regions and the underlying NWELL, but preserving the halo layer at inner sides of the S and D regions at the ends of the channel under the gate POLY of the PMOS transistor. The P+ S/D implant is introduced in a two step dual angle implant similar to the N-LDD implant so that the reserved N type halo is symmetrical at the inner sides of the S and D regions.

An advantage of these steps is that the process leaves a localized halo of N type dopant material at the ends of the channel under the polygate and between the S and D regions of PMOS transistors having a higher concentration of N type carriers than the PMOS transistor NWELL. The localized PMOS halo PHLDD of N type dopant material affords added punch through protection between the S and D regions of the PMOS transistors. At the same time parasitic capacitance along the major portion of the horizontal interface between S and D regions and the underlying NWELL of PMOS transistors is reduced by the erasure.

Finally an NMOS transistor N+S/D definition mask, etch and N type dopant material introduction sequence introduces relatively high N+ concentration S and D regions in the PWELL of NMOS transistors over the N type LDD layer N-LDD. The process proceeds by adjusting the N+S/D implant for retaining a portion of the N-LDD layer along the horizontal interface between the NMOS transistor S and D regions and underlying PWELL. A further advantage of these steps is that the process reduces parasitic capacitance between S and D regions and underlying PWELL of NMOS transistors. These steps also provide an N type LDD layer N-LDD at the ends of the channel of NMOS transistors for hot electron protection of the gate oxide layer GOX.

In the case of a BICMOS IC fabrication process, the step of annealing the emitter region and collector sink contact region for bipolar transistors precedes the P+S/D mask implant for CMOS/PMOS transistors. The emitter anneal step is used to advantage for driving the N type halo layer PHLDD into the ends of the channel between S and D regions under the PMOS transistor polygate. The annealing step is used to control the magnitude of the localized N type halo region which remains at the ends of the channel. The new dual angle P+S/D implant is then adjusted to erase the halo layer at the horizontal interface between the P+ S and D regions and the PMOS transistor NWELL while retaining the localized PMOS halo PHLDD at the ends of the PMOS channel. The P+ S/D implant does not migrate or diffuse as far as the N-LDD implant into the channel leaving the N type "halo" at the channel boundaries. The new dual angle P+ S/D implant assures symmetry of the N type halo.

A feature of the new process steps and resulting source and drain region architecture for PMOS transistors is that the punch through protection between source and drain regions is enhanced by 20% to 30%, for example, by three volts to a ten volt punch through threshold protection. Furthermore, this is accomplished without substantially increasing the parasitic capacitance across the active area of the PMOS transistor. This is because the punch through threshold voltage protection is enhanced without generalized increase of doping concentration in the NWELL. The increased punch through protection is provided by the localized halo with increased concentration of N type carriers confined to the ends of the channel.

In the preferred example embodiment of the CMOS/PMOS transistor structure, the NWELL is formed with an N-- concentration of N type impurity carriers, the N-LDD localized halo layer PHLDD is formed with an N- concentration of N type carriers, and the PMOS source and drain regions are formed with a P+ concentration or P++ concentration of P type carriers. The NWELL dopant material is phosphorus, the dopant material of the localized halo PHLDD is phosphorus, and the P+S/D dopant material is boron.

Furthermore, the operating voltage threshold V_{T} of PMOS transistors is improved by the new localized halo region PHLDD. According to the invention, the PMOS operating voltage threshold V_{T} is established by a substantially equal contribution from three process steps, the retro NWELL mask implant, a conventional voltage threshold V_{T} adjust process step comprising a blanket implant of P type dopant material in the active areas of CMOS transistors, and the process steps forming the N type halo layer PHLDD in PMOS transistors.

Other objects, features and advantages of the invention are apparent in the following specification and accompanying drawings.

### Brief Description of the Drawings

Figures 1 and 2 are simplified fragmentary diagrammatic views through a CMOS transistor active area of a die on a wafer during fabrication in a CMOS or BICMOS process showing in Figure 1 the deposition of the polysilicon layer POLY and in Fig. 2 the polygate mask and etch sequence leaving polygates over PMOS and NMOS transistors.

Figure 3 is a simplified fragmentary diagrammatic view through the CMOS transistor active area showing the dual angle N-LDD implant using the polygates POLY and field oxide regions FOX as SAT masks while Fig. 3A is a similar enlarged view of the rectangular area designated 3A in Fig. 3.

Figures 4 and 5 are simplified fragmentary diagrammatic views through the CMOS transistor area showing respectively the P+S/D and N+S/D mask, etch and introduction sequences for forming the source and drain regions of the PMOS and NMOS transistors.

Figure 6 is a simplified fragmentary diagrammatic view through a PMOS transistor active area showing the new source and drain architecture with localized N type halo PHLDD according to the invention.

Figure 7 is a graph of impurity carrier concentrations along a horizontal line extending left to right through the PMOS transistor of Fig. 6 below but near the surface.

Figure 8 is a simplified diagrammatic plan view of the active area of the PMOS transistor of Fig. 6.

Figure 9 is a simplified diagrammatic view through the CMOS transistor area showing the new P+ S/D mask, etch, and two step dual angle implant sequence for forming the S and D regions of PMOS transistors.

### Description of Preferred Example Embodiments and Best Mode of the Invention

The new IC fabrication steps according to the invention applicable for either CMOS or BICMOS IC fabrication processes is illustrated by way of example, as follows. The retro NWELL mask, etch and N type impurity introduction sequence is implemented by implanting a dosage of, for example 4.25 x 10¹³ (4.25E13) ions/cm² of phosphorous with an energy of 80KEV in the retro NWELL regions. This step initiates the retrograde concentration NWELL's for PMOS transistors of the CMOS transistor structures. In the BICMOS process this represents the 2.0 PMOS retro NWELL mask, etch and N type carrier introduction sequence.

Following the 8.0 polygate definition mask and etch sequence of the BICMOS IC fabrication process of TABLE I, the N-LDD introduction sequence is carried out by the dual angle blanket implant. In the first step, a dose of for example 1.5E13 ions/cm² of phosphorous is implanted with an energy of 60KEV at an angle of +7° from the horizontal. A similar implant is carried out at -7° implant angle from the vertical. As a result a total dosage of 3E13 ions/cm² of phosphorous is implanted at 60KEV energy through the polygate and FOX self aligned transistor masks into the source and drain regions of the NWELL's and PWELL's of the respective PMOS and NMOS transistors as illustrated in Figs. 3 and 3A.

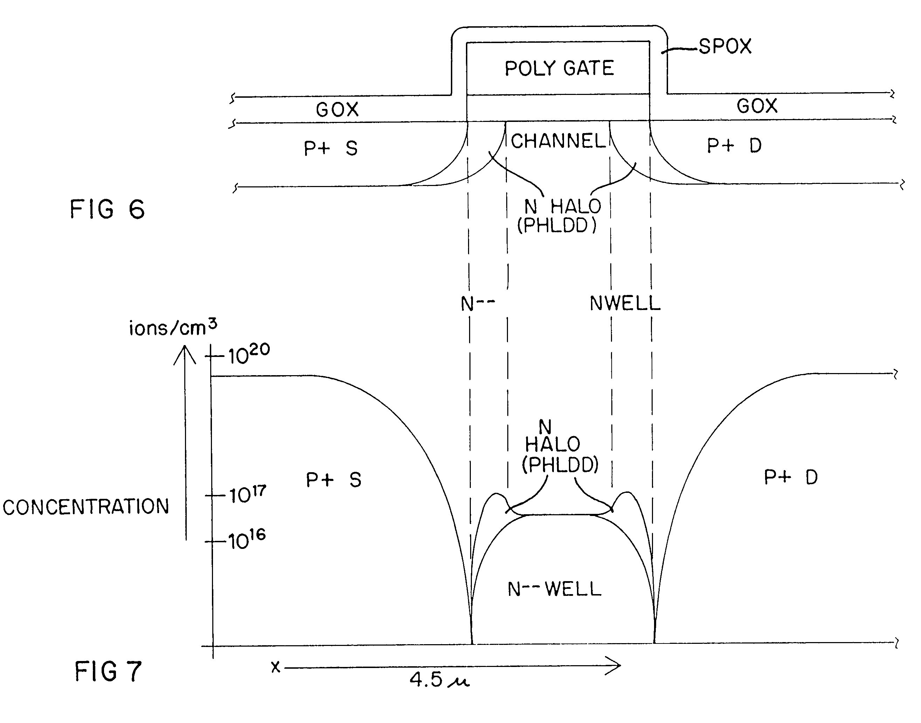

In the BICMOS process the N- concentration halo layer is driven further under the polygate into the ends of the channel between the source S and drain D regions of the PMOS transistor by the emitter anneal step which precedes the P+S/D mask, etch and P type introduction sequence. An appropriate emitter annealing sequence for this purpose is described for example in the U.S. Patent Application Serial No. 905,772 filed June 29, 1992 for SIMPLIFIED HIGH RELIABILITY GATE OXIDE PROCESS, referenced above. The emitter anneal cycle includes thirty minutes at 1000°C and is used to control the size of the subsequent halo formed at the ends of the channel under the polygate as illustrated in Fig. 6. According to one example the emitter anneal temperature ramps from 850°C to 1000°C over nineteen minutes, is held at 1000°C for approximately thirty minutes, and ramps down to 850°C over an additional thirty-eight minutes.

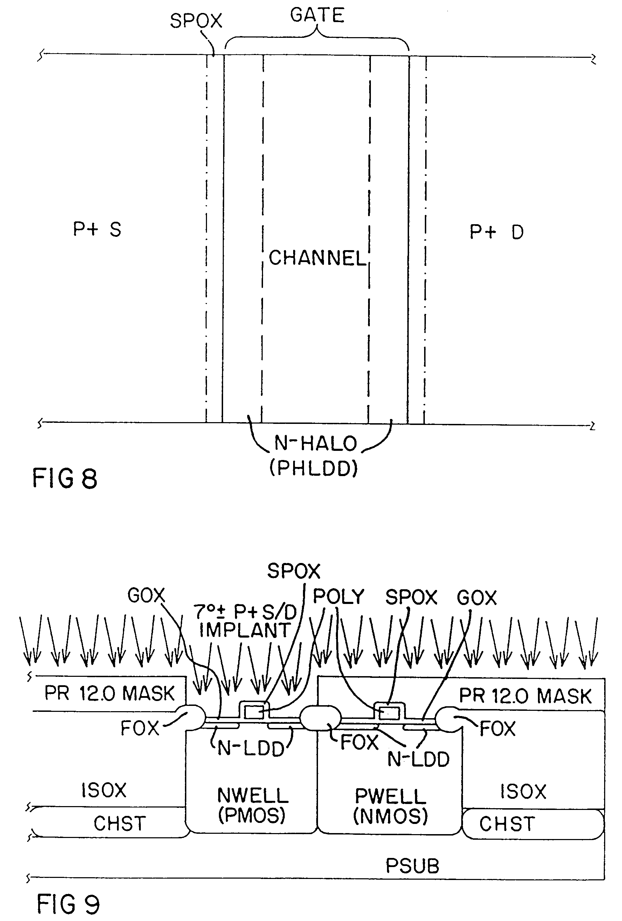

In the subsequent P+ source/drain mask, etch, and P type introduction sequence, the P+ source and drain regions of the PMOS transistors are formed and at the same time the N type halo layer is selectively erased. To this end a P+S/D dosage of, for example, two doses each of 1.5 x 10¹⁵ (1.5E15) ions/cm² for a total dosage of 3X10¹⁵ (3E15) ions/cm² of boron difluoride is implanted at 80KEV energy through the 12.0 PMOS P+S/D mask in a dual angle implant at, for example, +/-7° as shown in Fig. 9. The P+S/D implant is selected and controlled according to this example to "swamp" the N type halo layer along the horizontal active area of the source and drain regions and at the interface between the P+ S and P+ D regions and the PMOS transistor NWELL. The N-LDD implant and resulting N type halo layer was driven further into the ends of the channel by the previous annealing step than is reached by the later P+S/D implant. The P+S/D implant is also controlled to retain the portion of the N type halo layer underlying the polygate POLY to form a localized halo region PHLDD at the ends of the channel between the source and drain regions as illustrated in Fig. 6. The dual angle implant is performed in two implant steps at small opposite angles of, for example, +/- 7° to preserve the symmetry of the halo.

According to the preferred example the resulting concentrations of P type and N type carriers in the respective active regions near the surface of the NMOS transistor of Fig. 6 are illustrated in the graph of Fig. 7. In the P+ source and drain regions, the P+ concentration of P type carriers is in the range of for example 1-6 x 10¹⁹ (1-6E19) ions/cm³. On the other hand the retrograde NWELL may have a typical N-- concentration near the upper surface of the NWELL in the range of, for example, 1-5 x 10¹⁶ (1-5E16) ions/cm³. This low concentration of N type carriers would normally afford a punch through voltage threshold protection for the PMOS transistor of only approximately 7 volts. However according to the new process and halo structure, the halo region PHLDD is characterized by an N-concentration of N type carriers in the range of approximately 1 x 10¹⁷ (1E17) ions/cm³ at each end of the channel as illustrated in Figs. 6 and 7. This localized halo increase of N type concentration carriers enhances the punch through voltage protection by 20% - 30% elevating the punch through voltage threshold from reverse biasing, for example, by 3 volts from 7 volts to 10 volts.

This enhanced punch through voltage threshold protection is attained without a generalized increase in the surface concentration of N type carriers of the NWELL. Enhanced punch through protection is therefore achieved without substantial increase in parasitic capacitance between the NWELL and P+ source and drain regions. The NWELL is characterized by a retrograde concentration of carriers from a higher concentration of for example 5 x 10¹⁷ (5E17) ions/cm³ near the bottom of the NWELL adjacent to the substrate to the substantially lower N-- concentration of 1E16 ion/cm³ at the surface and interface with the P+ source and drain regions. This lower concentration and lower accompanying parasitic capacitance remains across the horizontal interface between the N-- NWELL and P+ source and drain regions as illustrated in Figs. 6 and 8.

The 13.0 NMOS N+S/D mask, etch and N+ introduction sequence follows the two step dual angle P+ S/D implant of Fig. 9. A dosage of 3 x 10¹⁵ (3E15) ions/cm² is implanted at an energy level of 100KEV in the source and drain regions of the NMOS transistors. This dosage and implant energy are adjusted and controlled to retain a portion of the N-LDD layer between the P- concentration PWELL and the N+ source and drain regions. The intermediate N-LDD layer reduces capacitance between the NMOS transistor P- concentration PWELL and N+ concentration source and drain regions. The N- LDD layer is also preserved at the sides of the source and drain regions and NMOS transistor channel to protect the gate oxide GOX from hot electrons.

An advantage of the PMOS transistor halo structure is that it also improves the operating threshold V_{T} of the PMOS transistor. The peaks of concentration of the halo at the ends of the channel permit finer tuning of the operating threshold V_{T}. In the preferred example the halo structure PHLDD is controlled to contribute approximately one third of the threshold voltage level V_{T}. Another one third contribution of the threshold voltage V_{T} is achieved by controlling the doping concentration of the PMOS transistor NWELL. The final one third component of threshold voltage V_{T} is controlled by the traditional voltage threshold V_{T} adjust blanket P type boron implant which is part of the 7.0 active strip mask and etch sequence. The 7.0 mask sequence is also known as the active strip, voltage threshold V_{T} adjust, and gate oxide grow sequence or gate oxide loop. An advantage of the halo structure is that the peaks of concentration of N type carriers at the edges of the channel provide more sensitive control over the turn on voltage V_{T}.

While the invention has been described with reference to particular example embodiments it is intended to cover all modification and equivalents within the scope of the following claims.

## Claims

1. An IC fabrication process incorporating CMOS fabrication steps for preparing CMOS transistors in a substrate of semiconductor material, said CMOS transistors comprising NMOS transistors having a PWELL, spaced apart source (S) and drain (D) regions of N type dopant material in the PWELL, and a polysilicon gate (polygate) separated by a gate oxide (GOX) layer from the source and drain regions and PWELL, said polygate defining a channel in the PWELL under the polygate between the S and D regions, and PMOS transistors having an NWELL, spaced apart source (S) and drain (D) regions of P type dopant material formed in the NWELL, and a polygate separated from source and drain regions and NWELL by a gate oxide (GOX) layer, said polygate defining a channel in the NWELL under the polygate between the S and D regions, the improvement for hot electron protection for the GOX of NMOS transistors, for enhanced punch through protection between S and D regions for PMOS transistors, and for reducing parasitic capacitance across active areas of CMOS transistors comprising:
introducing a relatively low dose of N type dopant material in the S and D regions of CMOS transistors using the polygate as a self aligned transistor (SAT) mask, and forming a low doped N type LDD layer in the S and D regions of NMOS transistors and a low doped N type halo layer PHLDD in the S and D regions of PMOS transistors, said N type halo layer having a relatively higher concentration of N type carriers than the NWELL near the surface of PMOS transistors;
a PMOS transistor P+S/D definition mask, etch and P type dopant material introduction sequence comprising introducing relatively high P+ concentration S and D regions in the PMOS transistors over the halo layer, and adjusting the P+S/D introduction sequence for erasing the halo layer along the horizontal interface between the PMOS transistor S and D regions and underlying NWELL, but preserving the halo layer at inner sides of the S and D regions at the ends of the channel under the polygate of the PMOS transistors thereby leaving a localized halo of N type dopant material for added punch through protection between the S and D regions of PMOS transistors without increasing parasitic capacitance along the major portion of the horizontal active area between S and D regions and underlying NWELL of PMOS transistors;
and an NMOS transistor N+S/D definition mask, etch and N type dopant material introduction sequence introducing relatively high N+ concentration S and D regions in the NMOS transistors over the LDD layer, and adjusting the N+S/D introduction sequence for retaining a portion of the LDD layer along the horizontal interface between the NMOS transistor S and D regions and underlying PWELL for reducing parasitic capacitance between S and D regions and underlying PWELL of NMOS transistors, and also providing an N type LDD layer at the ends of the channel under the polygate of NMOS transistors for hot electron protection of GOX.

2. The IC fabrication process of claim 1 wherein the step of introducing a relatively low dose of N type dopant material comprises implanting an N- concentration of N type dopant material in the S and D regions of NMOS and PMOS transistors forming an N-LDD layer in the NMOS transistors and an N- halo layer in PMOS transistors using the polygate as an SAT mask and using dual angle implants at opposite angles from the vertical for reducing shadow effects of the SAT mask; and wherein the step of introducing a relatively high P+ concentration S and D regions in the PMOS transistor over the halo layer comprises implanting P type dopant material using dual angle implants at opposite angles from the vertical.

3. The IC fabrication process of claim 2 wherein the NWELL of PMOS transistors comprises a retrograde concentration NWELL having a relatively low N-- concentration of N type dopant material near the surface of the NWELL, wherein the N-LDD layer and halo layer PHLDD comprise a relatively low N- concentration of N type dopant material, and wherein the PMOS transistor S and D regions comprise relatively high P+ concentration of P type dopant material.

4. The IC fabrication process of claim 3 wherein the NWELL N type dopant material comprises phosphorus, wherein the N-LDD layer and halo layer PHLDD N type dopant material comprises phosphorus, wherein the NMOS transistor N+ S and D regions comprise an N type dopant material of arsenic, and wherein the PMOS transistor P+ S and D regions comprise a P type dopant material of boron.

5. The IC fabrication process of claim 4 wherein the N-- concentration of N type dopant material in the NWELL is in the concentration range of approximately 1-5 x 10¹⁶ ions/cm³; wherein the N- concentration of N type dopant material in the N-LDD layer and halo layer PHLDD is in the concentration range of approximately 1 x 10¹⁷ ions/cm³; wherein the N+ concentration of N type dopant material in the NMOS transistor S and D regions is in the concentration range of approximately 1 x 10²⁰ ions/cm², and wherein the P+ concentration of P type dopant material is in the concentration range of 1-6 X10¹⁹ ions/cm₃.

6. The IC fabrication process of claim 1 wherein the process is a BICMOS IC fabrication process having an emitter annealing step before the P+S/D definition mask, etch, and introduction sequence, and comprising the step of using the emitter annealing step for driving the N type halo layer PHLDD under the polygate and into the ends of the channel under the polygate between the S and D regions of the PMOS transistors for controlling the dimensions of the localized halo to be left by the P+S/D definition mask, etch, and introduction sequence.

7. The IC fabrication of claim 1 wherein the operating voltage threshold (V_{T}) of PMOS transistors is established primarily by three CMOS fabrication process steps comprising a process step of introducing N type dopant material into the NWELL, a V_{T} adjust process step comprising a blanket implant of P type dopant material in the active areas of CMOS transistors, and a process step of introducing N type dopant material into the LDD layer and halo layer.

8. The IC fabrication process of claim 7 wherein the three process steps make substantially equal contributions to establishing the operating voltage threshold (V_{T}) of PMOS transistors.

9. An integrated circuit CMOS transistor structure having NMOS and PMOS transistors produced by the process of claim 1 and having concentration ranges of dopant material across the active area of the respective PMOS transistor substantially as shown in Fig. 7.

10. An IC fabrication process incorporating CMOS fabrication steps for preparing CMOS transistors in a substrate of semiconductor material including an NWELL definition mask, etch and N type dopant material introduction sequence providing a relatively low N-- concentration NWELL in the substrate for PMOS transistors, a PWELL definition mask, etch and P type dopant material introduction sequence providing a relatively low P- concentration PWELL in the substrate for NMOS transistors, growing an epitaxial silicon layer by epitaxial deposition across the substrate, growing an epitaxial oxide (EPIOX) layer across the epitaxial layer and depositing a nitride layer (SIN) by chemical vapor deposition (CVD) over the EPIOX layer, an active area definition mask, etch, and field oxide (FOX) grow sequence for defining and framing the active areas of CMOS transistors in FOX, an active strip mask, etch, voltage threshold (V_{T}) adjust and gate oxide (GOX) grow sequence for adjusting the threshold voltage of CMOS transistors and preparing the surface of the CMOS transistor active areas for receiving a CMOS transistor gate, depositing a layer of polysilicon across the IC followed by a polygate definition mask and etch sequence for forming a polygate POLY over the GOX of CMOS transistor active areas, said polygate defining a channel in respective NWELL's and PWELL's under the respective polygates between source (S) and drain (D) regions, and forming a seal oxide (SPOX) over the respective polygates, the improvement for hot electron protection of the GOX of NMOS transistors and for enhanced punch through protection between source and drain regions of PMOS transistors, without substantially increasing parasitic capacitance across active areas of CMOS transistors, comprising:
introducing a relatively low dose of N type dopant material in S and D regions of CMOS transistors using the polygate as a self aligned transistor (SAT) mask, and forming a low doped N type LDD layer in the S and D regions of NMOS transistors and a low doped N type halo PHLDD layer in the S and D regions of PMOS transistors, said N type halo layer having a relatively higher concentration than the NWELL near the surface of PMOS transistors;
a PMOS transistor P+S/D definition mask, etch and P type dopant material introduction sequence introducing relatively high P+ concentration S and D regions in the PMOS transistors over the halo layer, and adjusting the P+S/D introduction sequence for erasing the halo layer along the horizontal interface between the PMOS transistor S and D regions and underlying NWELL, but preserving the halo layer at inner sides of the S and D regions at the ends of the channel under the polygate of the PMOS transistors thereby leaving a localized halo of N type dopant material for added punch through protection between the S and D regions of PMOS transistors without increasing parasitic capacitance along the major portion of the horizontal active area interface between S and D regions and underlying NWELL of PMOS transistors;
and an NMOS transistor N+S/D definition mask, etch and N type material introduction sequence introducing relatively high N+ concentration S and D regions in the NMOS transistors over the LDD layer, and adjusting the N+S/D introduction sequence for retaining a portion of the N type LDD layer along the horizontal interface between the NMOS transistor S and D regions and underlying PWELL for reducing parasitic capacitance between S and D regions and underlying PWELL of NMOS transistors, and also providing an N type LDD layer at the ends of the channel under the polygate of NMOS transistors for hot electron protection of GOX.

11. The IC fabrication process of claim 10 wherein the step of introducing a relatively low dose of N type dopant material to form the LDD layer and halo layer comprises implanting an N- concentration of N type dopant material in the S and D regions of NMOS and PMOS transistors forming an N-LDD layer in the NMOS transistors and an N- halo layer in the PMOS transistors using the polygate as an SAT mask and using dual angle implants at opposite angles from the vertical for reducing shadow effects of the SAT mask; and wherein the step of introducing a relatively high P+ concentration S and D regions in the PMOS transistor over the halo layer comprises implanting P type dopant material using dual angle implants at opposite angles from the vertical.

12. The IC fabrication process of claim 10 wherein the NWELL of PMOS transistors comprises a retrograde concentration NWELL having a relatively low N-- concentration of N type dopant material near the surface of the NWELL, wherein the N-LDD layer and halo layer PHLDD comprise a relatively low N- concentration of N type dopant material, and wherein the PMOS transistor S and D regions comprise relatively high P+ concentration of P type dopant material.

13. The IC fabrication process of claim 12 wherein the NWELL N type dopant material comprises phosphorus, wherein the N-LDD layer and halo layer PHLDD N type dopant material comprises phosphorus, wherein the NMOS transistor N+ S and D regions comprise an N type dopant material of arsenic, and wherein the PMOS transistor P+ S and D regions comprise a P type dopant material of boron.

14. The IC fabrication process of claim 13 wherein the N-- concentration of N type dopant material in the NWELL is in the concentration range of approximately 1-5 x 10¹⁶ ions/cm³; wherein the N- concentration of N type dopant material in the N-LDD layer and halo layer PHLDD is in the concentration range of approximately 1 x 10¹⁷ ions/cm³; wherein the N+ concentration of N type dopant material in the NMOS transistor S and D regions is in the concentration range of approximately 1 x 10²⁰ ions/cm², and wherein the P+ concentration of P type dopant material is in the concentration range of 1-6 X10¹⁹ ions/cm³.

15. The IC fabrication process of claim 10 wherein the process is a BICMOS IC fabrication process having an emitter annealing step before the P+S/D definition mask, etch, and introduction sequence, and comprising the step of using the emitter annealing step for driving the N type halo layer PHLDD under the polygate and into the ends of the channel under the polygate between the S and D regions of the PMOS transistors for controlling the dimensions of the localized halo to be left by the P+S/D definition mask, etch, and introduction sequence.

16. The IC fabrication process of claim 10 wherein the operating voltage threshold (V_{T}) of CMOS transistors is established primarily by three PMOS fabrication process steps comprising a process step of introducing N type dopant material into the NWELL, a V_{T} adjust process step comprising a blanket implant of P type dopant material in the active areas of CMOS transistors, and a process step of introducing N type dopant material into the LDD layer and halo layer.

17. The IC fabrication process of claim 16 wherein the three process steps make substantially equal contributions to establishing the operating voltage threshold (V_{T}) of PMOS transistors.

18. An integrated circuit CMOS transistor structure having NMOS and PMOS transistors produced by the process of claim 10 and having concentration ranges of dopant material across the active area of the respective PMOS transistor substantially as shown in Fig. 7.

19. CMOS transistors in a substrate of semiconductor material, said CMOS transistors comprising NMOS transistors having a PWELL, spaced apart source (S) and drain (D) regions of N type dopant material in the PWELL, and a polysilicon gate (polygate) separated by a gate oxide (GOX) layer from the source and drain regions and PWELL, said polygate defining a channel in the PWELL under the polygate between the S and D regions, and PMOS transistors having an NWELL, spaced apart source (S) and drain (D) regions of P type dopant material formed in the NWELL, and a polygate separated from source and drain regions and NWELL by a gate oxide (GOX) layer, said polygate defining a channel in the NWELL under the polygate between the S and D regions, the improvement for hot electron protection for the GOX of NMOS transistors, for enhanced punch through protection between S and D regions for PMOS transistors, and for reducing parasitic capacitance across active areas of CMOS transistors comprising:
a low doped N type LDD layer in the S and D regions of NMOS transistors forming a graded concentration profile between N+ S and D regions and P- PWELL;
relatively high P+ concentration S and D regions in the NWELL of PMOS transistors;
an N type halo at inner sides of the S and D regions at the ends of the channel under the gate of the PMOS transistors forming a localized halo PHLDD of N type dopant material for added punch through protection between the S and D regions of PMOS transistors without increasing parasitic capacitance along the major portion of the horizontal active area between S and D regions and underlying NWELL of PMOS transistors, said halo PHLDD having a concentration of N type carriers greater than the NWELL where the halo meets the NWELL and being substantially symmetrical along the inner sides of the S and D regions;
and relatively high N+ concentration S and D regions in the NMOS transistors over the LDD layer, a portion of the LDD layer lying along the horizontal interface between the NMOS transistor S and D regions and underlying PWELL and providing the graded concentration profile for reducing parasitic capacitance between S and D regions and underlying PWELL of NMOS transistors, said N type LDD layer also being located at the ends of the channel under the polygate of NMOS transistors for providing hot electron protection for GOX.

20. The CMOS transistors of claim 19 wherein the NWELL of PMOS transistors comprises a retrograde concentration NWELL having a relatively low N-- concentration of N type dopant material near the surface of the NWELL, wherein the LDD layer and halo layer comprise a relatively low N- concentration of N type dopant material, and wherein the PMOS transistor S and D regions comprise relatively high P+ concentration of P type dopant material;
said N-- concentration of N type dopant material in the NWELL being in the concentration range of approximately 1-5 x 10¹⁶ ions/cm³, said N- concentration of N type dopant material in the LDD layer and halo layer being in the concentration range of approximately 1 x 10¹⁷ ions/cm³, said N+ concentration of N type dopant material in the NMOS transistor S and D regions being in the concentration range of approximately 1 x 10²⁰ ions/cm², and said P+ concentration of P type dopant material in the PMOS transistor S and D regions being in the concentration range of 1-6 x10¹⁹ ions/cm₃.
